(19)

Europäisches
Patentamt
European
Patent Office
Office européen
des brevets

(11) **EP 1 930 305 A1**

(12) **EUROPEAN PATENT APPLICATION**
published in accordance with Art. 153(4) EPC

(43) Date of publication:
**11.06.2008 Bulletin 2008/24**

(51) Int Cl.:
***C04B 35/111*** (2006.01)     ***C04B 35/581*** (2006.01)
***H01L 33/00*** (2006.01)

(21) Application number: **06810536.0**

(22) Date of filing: **26.09.2006**

(86) International application number:
**PCT/JP2006/319011**

(87) International publication number:
**WO 2007/034955 (29.03.2007 Gazette 2007/13)**

(84) Designated Contracting States:
**DE FR GB NL**

(30) Priority: **26.09.2005 JP 2005277048**

(71) Applicant: **Tokuyama Corporation**
**Shunan-shi, Yamaguchi 745-8648 (JP)**

(72) Inventors:
  • **SUGAWARA, Ken**
    **Shunan-shi**
    **Yamagushi 745-8648 (JP)**
  • **MINABE, Yuichiro**
    **Shunan-shi**
    **Yamaguchi 745-8648 (JP)**

• **YONEDA, Takehiko**
  **Shunan-shi**
  **Yamaguchi 745-8648 (JP)**
• **ARIYUKI, Masao**
  **Shunan-shi**
  **Yamaguchi 745-8648 (JP)**

(74) Representative: **Smart, Peter John**
**Beck Greener**
**Fulwood House,**
**12 Fulwood Place,**
**London WC1V 6HR (GB)**

(54) **SINTERED CERAMICS FOR MOUNTING LIGHT EMITTING ELEMENT**

(57)    The present invention provides a sintered ceramics for mounting light-emitting element, which is capable to realize high optical reflectance over the entire region from ultraviolet radiation to visible light; the sintered ceramics for mounting light-emitting element comprising a sintered ceramics, wherein the sintered ceramics has a light-reflective face of which reflectance to light in each wavelength in the range of 250nm~750nm is 70% or more; the light-reflective face satisfies following relation (1) :

$$|R_A - R_B| \leqq 20 \qquad (1)$$

when reflectance to light of 750nm is defined as $R_A$%, and reflectance to light of 300nm is defined as $R_B$%; and the sintered ceramics has no layer to be peeled from the light-reflective face when Tape Peeling Test is carried out to the light-reflective face in accordance with the method described in JIS H8504 (1990).

FIG. 1

**Description**

Technical Field

The present invention relates to a new sintered ceramics for mounting light-emitting element. More specifically, it relates to a sintered ceramics for mounting light-emitting element, which has excellent optical reflectance and is used for mounting light-emitting element, particularly light-emitting diode (hereinafter, refer to as "LED".), and so on.

Background Art

In recent years, development of light-emitting element like LED not only covers monochromatic LEDs emitting in red, green, blue and so on, but also reaches commercialization of white LED which can be obtained by applying fluorescent material to blue LED. Further, as the brightness of these LEDs is improved, these LEDs become frequently used for such as light source of electronic billboards, cell phones, and back-light source of computers.

Blue LED, in general, uses GaN series compound semiconductor. The manufacturing method thereof is: firstly, generally, preparing insulating sapphire as a substrate, and then forming p-side and n-side electrodes on the surface of the compound semiconductor laminated on the substrate; this blue LED is used for the so-called "flip-chip light-emitting element" being mounted on a board at the surface of these electrodes. Since such a flip-chip light-emitting element has sapphire as the board which is optically transparent, it is capable to mount the light-emitting element on the board such that the sapphire substrate faces toward the direction of light-emitting, so as to use the surface of sapphire substrate as a main surface of light-extraction. These days, in addition to the mounting chip of light-emitting element on the board, complex light-emitting element mounted on a submount element for inhibiting static electricity by e.g. zener diode is used as a useful light source.

These complex light-emitting elements have a structure where a blue flip-chip light-emitting element is conductively mounted on the submount to be mounted on a mounting board incorporated in electronic devices. Conventionally, as a submount, silicon substrate has been used. However, as the silicon substrate absorbs light of which wavelength is 450nm (blue) - 560nm (green) emitted from LED, there is a problem of lowering brightness of the complex light-emitting element.

Because of this, as a complex light-emitting element which does not have such a problem, a light-emitting element of which mounting face is constituted by white-color insulator such as aluminum oxide is proposed (see Patent Document 1.).

On the other hand, about spectroscopic analysis of visible and ultraviolet radiation, integrating sphere is used for measuring specular reflected light and diffuse reflected light. On the inner face of the integrating sphere, a substance, normally barium sulfate, is applied for reflecting visible and ultraviolet radiation. Moreover, as a reference substance for 100% reflection, plates made of barium sulfate and aluminum oxide are used.

Patent Document 1: Japanese Patent Application Laid-Open (JP-A) No. 2003-60243

Disclosure of the Invention

Problems to be solved by the Invention

However, although the generally available aluminum oxide sintered ceramics shows relatively high optical reflectance to visible light, the optical reflectance to light in the region of ultraviolet radiation (e.g. 250-350nm) is low. So, when it is used for a submount for white LED having LED emitting ultraviolet radiation, the brightness is not sufficiently enough.

Further, the reference substance for measuring light reflection at the integrating sphere shows higher optical reflectance. However, it is extremely brittle, for example, there are some of which surface tend to become powdery and peeled with a slight touch of finger. Therefore, it is impossible to use such a reference substance for applications like submount for LED.

Accordingly, an object of the present invention is to provide a sintered ceramics for mounting light-emitting element which realizes high optical reflectance over the entire region from ultraviolet radiation to visible light, and also a ceramics package for light-emitting element using the above sintered ceramics.

Means for Solving the Problems

The present inventors have been conducted serious studies in order to solve the above problem. As a result, the present inventors have acquired an idea that aluminum oxide substrate obtained by oxidation treatment of sintered aluminum nitride substrate shows reflectance to light in each wavelength in the range of 250~750nm is 70% or more. Further studies based on this idea reached the fact that the above aluminum oxide substrate has many microscopic voids and it is capable to control number of the voids and distribution of the diameter to some extent by controlling the oxidation condition. Accordingly, the present inventors reach an idea that if minute foreign substances (e.g. voids and microparticles), of which reflectance is largely different from that of base material and of which distribution of diameter is controlled, is introduced into the sintered ceramics, it is capable to enhance the optical reflectance of the sintered ceramics by use of diffused reflection of light caused in the interface of these foreign substances and the base material to achieve the above object; then, the inventors completed the present invention described as follows.

The first aspect of the present invention is a sintered ceramics for mounting light-emitting element comprising a sintered ceramics, wherein the sintered ceramics has a light-reflective face of which reflectance to light in each wavelength in the range of 250nm~750nm is 70% or more; the light-reflective face satisfies following relation (1):

$$\left| R_A - R_B \right| \leqq 20 \qquad\qquad (1)$$

when reflectance to light of 750nm is defined as $R_A$%, and reflectance to light of 300nm is defined as $R_B$%;

and the sintered ceramics has no layer to be peeled from the light-reflective face when Tape Peeling Test is carried out to the light-reflective face in accordance with the method described in JIS H8504 (1990).

In the sintered ceramics of the invention, as the reflectance to light in each wavelength in the range of 250nm~750nm is 70% or more, which is high, when the sintered ceramics of the invention is used for ceramics substrate for mounting light-emitting element or ceramics package material for the light-emitting element, it is capable to efficiently reflect light generated from side and back of elements and to enhance brightness of the light-emitting element. Such a practical ceramics material of which reflectance to light of overall wavelength, particularly ultraviolet radiation is high has been hardly ever known. Consequently, the sintered ceramics of the present invention is extremely useful as a substrate for white LED elements using LED radiating near-ultraviolet radiation or the package materials.

Moreover, in the sintered ceramics of the invention, wavelength dependence of the optical reflectance is less, the gap between the reflectance to light of 750nm and reflectance to light of 300nm is 20% or less, which is small. So, when white LED is made using LED radiating blue-light or near-ultraviolet radiation, range of choice of fluorescent material for realizing white-light emitting is widened, but also control of wavelength distribution of the obtained white-light becomes easier; thereby it is capable to realize high color rendering property of white-light emitting.

In the first aspect of the invention, a specific region from surface of at least one face to at least $15\mu$m depth of the sintered ceramics preferably has a plurality of voids of which diameter is 100nm~2000nm and those voids are mutually independent, ratio of number of the voids of less than 400nm in diameter to total number of the voids is preferably 30~90%, and ratio of number of the voids of 400nm or more and less than 800nm in diameter to total number of the voids is preferably 10~70%.

Here, "at least one face of the sintered ceramics" means a surface of a side of this sintered ceramics where light-emitting elements are mounted. On the surface of the side where light-emitting elements are mounted, a part of light from the light-emitting elements are radiated. In order to reflect the light, a specific region must be provided at least on this surface. In the sintered ceramics for mounting light-emitting element of the invention, by providing the specific region of the surface a constitution having certain ratio of voids having predetermined diameter, it is possible to suitably realize the above-described high-reflectance characteristics.

Further, ratio of total volume of the voids to total volume of the specific region (ceramics portion plus voids portion) is preferably 5~30%. By forming voids in this ratio, it is capable to make the reflectance better and also to secure the geometric strength. In addition, the specific region may be preferably formed by $\alpha$-alumina as a main component. Here, "as a main component" means that the component is contained at 80 mass % or more, preferably 90 mass % or more to total mass of the specific region (hereinafter, it means the same in this description.).

A specific embodiment of the sintered ceramics of the first aspect of the invention may be the one of which specific region contains $\alpha$-alumina as a main component and a portion other than the specific region contains aluminum nitride as a main component. With the sintered ceramics having the above constitution, it is possible to obtain two effects, i.e. high-reflectance by $\alpha$-alumina and high thermal conductivity attributed to aluminum nitride.

Another specific embodiment of the sintered ceramics of the first aspect of the invention may be the one of which specific region forms the entirety of the sintered ceramics, and the specific region contains $\alpha$-alumina as a main component. In this way, by forming the entire constitution with $\alpha$-alumina, it is capable to solve the problem of interface break-off between $\alpha$-alumina and aluminum nitride.

The second aspect of the present invention is a method for fabricating sintered ceramics for mounting light-emitting element of the first aspect of the invention, the method comprising the steps of: preparing a raw sintered ceramics capable to react with reactive gas; and forming the specific region by reacting the raw sintered ceramics and the reactive gas, wherein the reaction of the raw sintered ceramics and the reactive gas is carried out under a condition such that a plurality of voids of which diameter is 100nm~2000nm are formed in the specific region and the voids are mutually independent.

The third aspect of the present invention is a method for fabricating sintered ceramics for mounting light-emitting element of the first aspect of the invention, the method comprising the steps of: preparing a sintered aluminum nitride; and forming the specific region containing α-alumina as a main component by reacting the sintered aluminum nitride and oxygen, wherein the reaction of the sintered aluminum nitride and oxygen is carried out under a condition such that a plurality of voids of which diameter is 100nm~2000nm are formed in the specific region containing α-alumina as the main component and the voids are mutually independent.

The fourth aspect of the present invention is the sintered ceramics for mounting light-emitting element of which reflectance of the sintered ceramics to light in each wavelength in the range of 250nm~750nm is 75% or more. This fourth aspect of the invention can be suitably fabricated in accordance with the methods described in the following fifth and sixth aspects of the invention.

The fifth aspect of the present invention is a method for fabricating sintered ceramics for mounting light-emitting element of the fourth aspect of the sintered ceramics for mounting light-emitting element, the method comprising the steps of: preparing a sintered aluminum nitride; and heating the sintered aluminum nitride at a temperature of 1300˚C or more under atmosphere containing oxygen gas and of which dew point is set in the range of 0~15˚C, until the portion from surface to at least 15μm depth or more of the sintered aluminum nitride is oxidized into alumina, and for a period of time or more which requires to oxidize the portion from surface to at least 30μm depth of the sintered aluminum nitride into alumina when partial pressure of the oxygen gas is 0.21 atm.

The sixth aspect of the present invention is a method for fabricating sintered ceramics for mounting light-emitting element of the fourth aspect of the invention, the method comprising the steps of: preparing a sintered aluminum nitride containing at least one of sintering aides component; and heating the sintered aluminum nitride at a temperature of 1300˚C or more under atmosphere containing oxygen gas and of which dew point is set in the range of -70˚C or less, until the portion from the surface to at least 20μm depth of the sintered aluminum nitride is oxidized into alumina.

The seventh aspect of the present invention is a ceramics package for light-emitting element comprising the sintered ceramics for mounting light-emitting element of the first aspect of the invention.

Brief Description of the Drawings

FIG. 1 is a graph showing reflectance in each wavelength of sintered ceramics obtained by Examples 1~3 and Comparative examples 1, and 3~7;

FIG. 2 is a graph showing diameter of voids and ratio of number of the voids in each diameter observed in the sintered ceramics obtained by Example 1 and Comparative example 13;

FIG. 3 is a graph showing reflectance in each wavelength of the sintered ceramics obtained by Examples 4, 5 and Comparative examples 8~11;

FIG. 4 is a graph showing reflectance in each wavelength of the sintered ceramics obtained by Example 6 and Comparative example 12;

FIG. 5 is a graph showing reflectance in each wavelength of the sintered ceramics obtained by Comparative examples 13~19;

FIG. 6 is a graph showing reflectance in each wavelength of the sintered ceramics obtained by Examples 7~9 and Comparative examples 20, 21.

FIG. 7 is a graph showing diameter of voids and ratio of number of the voids in each diameter observed in the sintered ceramics obtained by Example 9 and Comparative example 21;

FIG. 8 is a graph showing reflectance in each wavelength of sintered ceramics obtained by Examples 10~12 and Comparative examples 22~27;

FIG. 9 is a graph showing reflectance in each wavelength of the sintered ceramics of Examples 13~15 and Comparative examples 28~32;

FIG. 10 is a graph showing reflectance in each wavelength of the sintered ceramics of Examples 16~18 and Comparative examples 33~38;

FIG. 11(a) is an SEM (scanning electron microscope) photo about cross section of oxidized layer of Comparative example 13 in 5000 magnification, FIG. 11(b) is the same in 30000 magnification; and

FIG. 12 (a) is an SEM photo about cross section of oxidized layer of Example 13 in 5000 magnification, FIG. 12 (b) is the same in 30000 magnification.

Best Mode for Carrying Out the Invention

< Sintered ceramics for mounting light-emitting element >

A sintered ceramics for mounting light-emitting element comprising a sintered ceramics, wherein the sintered ceramics has a light-reflective face of which reflectance to light in each wavelength in the range of 250nm~750nm is 70% or more; the light-reflective face satisfies following relation (1) :

$$\left| R_A - R_B \right| \leqq 20 \ (\%) \qquad (1)$$

when reflectance to light of 750nm is defined as $R_A$%, and reflectance to light of 300nm is defined as $R_B$% (hereinafter, the property may be referred to as "high-reflectance characteristics of the invention".). Here, "reflectance" means optical reflectance measured by reflectance measurement using integrating sphere where barium sulfate is applied to the depth and aluminum oxide white-plate for reflectance measurement as a reference substance giving 100% reflection. Accordingly, the light to be measured by the reflectance measurement is not only specular reflection but also including diffuse reflection. If reflectance of tested sample is higher than that of aluminum oxide white-plate for reflectance measurement, the reflectance may go over 100%.

Further, the sintered ceramics for mounting light-emitting element of the invention is a "sintered ceramics which has no layer to be peeled from the light-reflective face when Tape Peeling Test is carried out to the light-reflective face in accordance with the method described in JIS H8504 (1990)".

In the Tape Peeling Test described in JIS H8504, a piece of cellophane adhesive tape is adhered on the adhered surface, then the tape is peeled in the vertical direction. The sintered ceramics of the invention has no surface layer to be peeled by this Tape Peeling Test, it can be useful for submount for LED, and the like.

Generally-available sintered ceramics absorbs or transmits light in each wavelength in the range of 250nm~750nm. For example, although sintered alumina known as white ceramics shows high reflectance to light of 400nm-750nm, a sintered alumina which is especially prepared for a substrate having strength for mounting electronic materials can absorbs or transmits light of ultraviolet region. Therefore, the reflectance to light of 250nm~350nm is low (see below-described Comparative example 1.). Meanwhile, sintered alumina used for reference substance for light reflection measurement is extremely brittle (see Comparative example 2.).

On the other hand, in the sintered ceramics for mounting light-emitting element of the present invention, since many voids respectively having various size of diameter therein exist, interface of these voids and ceramics reflects or scatter the light in proportion to the size of the voids before the occurrence of light-absorption or light-transmission of the ceramics itself. Hence, it shows high reflectance to light in wide range of wavelength from ultraviolet region to visual-light region. Such an effect can be obtained not only by introducing voids, but also by introducing "microscopic particles (hereinafter, it may be referred to as "filler for diffused reflection".) consisting of ceramics material to become matrix (mother board) and material of which refractive index is largely different (a material in which difference of refractive index is preferably 0.5 or more, and more preferably 0.7 or more.)". Therefore, sintered ceramics for mounting light-emitting element of the invention may contain these embodiments.

As seen above, it is possible to realize high optical reflectance, material for sintered ceramics for mounting light-emitting element of the present invention is not particularly limited. Thereby, any kind of materials known to provide the sintered ceramics can be used. Examples of these ceramics material include: oxide ceramics such as aluminum oxide, silicon oxide, zirconium oxide, magnesium oxide, and titanium oxide; nitride ceramics such as aluminum nitride, silicon nitride, and boron nitride; and so on.

However, so as to realize high optical reflectance in the visual-light region, among the above sintered ceramics, those of which at least one face (light-reflective face) in the sintered ceramics absorb less light in the visual-light region, e.g. aluminum oxide, zirconium oxide, titanium oxide, and the like are preferably used. Also, in view of possibility to introduce the above-described voids into the sintered body with ease, the at least one face may be preferably aluminum oxide, particularly α-alumina. Moreover, sintered ceramics of the present invention may consist of single component or a plurality of components. When the sintered ceramics consists of by a plurality of components, it may be a material formed by sintering mutually different ceramics particles, a material formed in a solid solution consisting of a ceramics with an element other than the element constituting the ceramics, or composite oxide and composite nitride. Further, it may have a lamination structure in which different type of ceramics layers are jointed (sintered). Furthermore, sintered ceramics for mounting light-emitting element of the invention may include sintering aides and glass component.

In the sintered ceramics for mounting light-emitting element of the invention, controlling voids which exist inside thereof, distribution of the diameter of filler for diffused reflection, number (density), and existing region makes it possible to control optical reflectance. In view of high degree of the effect obtained when elements are actually mounted on the substrate, the sintered ceramics for mounting light-emitting element of the invention has a light-reflective face of which reflectance to light in each wavelength in the range of 250nm~750nm is preferably 75% or more, and more preferably 80% or more. Moreover, reflectance ($R_A$) to light of 750nm and reflectance ($R_B$) to light of 300nm preferably satisfy the following relation (2).

$$\left| R_A - R_B \right| \leqq 15 \qquad\qquad (2)$$

Further, reflectance of the sintered ceramics to light in each wavelength in the range of 250nm~750nm is particularly preferably 90% or more.

The sintered ceramics for mounting light-emitting element of the invention includes sintered ceramics including many voids having various diameter therein. In view of high degree of optical reflectance of these sintered ceramics, specific region from surface of at least one face to at least 15$\mu$m depth of the sintered ceramics has a plurality of voids of which diameter is 100nm~2000nm and these voids are mutually independent. Ratio of number of the voids of less than 400nm in diameter to total number of the voids is in the range of 30~90%, and ratio of number of the voids of 400nm or more and less than 800nm in diameter to total number of the voids is preferably in the range of 10~70%.

Furthermore, so as to obtain preferable optical reflectance, ratio of number of the voids of less than 400nm in diameter to total number of the voids is preferably in the range of 35~75%, particularly preferably 40~80%, and ratio of number of the voids of 400nm or more and less than 800nm in diameter to total number of the voids is preferably in the range of 15~65%, particularly preferably 20~60%.

The above specific region is formed on at least one face of the sintered ceramics for mounting light-emitting element. This "at least one face" means a surface of side where light-emitting elements are mounted in the sintered ceramics for mounting light-emitting element. To the surface of the side where light-emitting elements are mounted, a part of light from the light-emitting elements is radiated. The surface reflects the light, therefore a specific region must be formed at least in the surface. Alternatively, the specific region may be formed in the entire surface of the sintered ceramics for mounting light-emitting element.

The "specific region" means a region from surface to at least 15$\mu$m depth of the sintered ceramics. By providing the specific region from surface to at least 15$\mu$m depth of the sintered ceramics to be a constitution having the above certain voids at a predetermined ratio, it is possible to give the above-described high-reflectance characteristics to the sintered ceramics for mounting light-emitting element of the invention. Thus, the specific region may be formed over the thickness of 15$\mu$m or more, or the whole sintered ceramics for mounting light-emitting element may be formed by the specific region. When the specific region is formed over the thickness of 15$\mu$m or more, it is capable to enhance the high-reflectance characteristics of the invention. Also, when the whole sintered ceramics is formed by the specific region, interface between the specific region and a region other than the specific region disappears; thereby it is advantageous in terms of inhibiting peeling at the interface.

In order to obtain the above reflectance, thickness of the specific region is preferably 20$\mu$m or more, and particularly preferably 30$\mu$m or more.

The distribution of these voids is not necessarily even over the entire sintered ceramics, in the vicinity of specific region (a region from the surface to at least 5$\mu$m depth, preferably 10$\mu$m of the sintered ceramics), it is preferably a distribution such that voids having various diameter are dispersed at random. In addition, number of voids is not particularly limited; in view of reflectance and geometric strength, ratio of total volume (void content) of the voids to total volume of the specific region (volume of ceramics portion plus voids portion) is preferably 5~30%, more preferably 7~25%, and particularly preferably 10~20%.

In addition, when the void content is set within the above range, "non-void" portion becomes larger, hence the strength of specific region becomes higher, thereby surface layer cannot be peeled by the Tape Peeling Test.

The diameter and volume of these voids can be determined based on the scanning electron microscope (SEM) photos of the cross-section of the sintered ceramics. Samples for the SEM photos may be made, for example, by cutting a sample by dicing machines, grinding the cut surface, and then coating 10nm thick of Pt by use of sputter coater. The diameter of the voids of the invention is provided by analyzing the SEM photos of the cross-section by image analysis software, and then, the diameter of those voids are calculated by finding out the diameter of circle equivalent to the circle having the same area as area (S) of the observed voids (objects). Further, the ratio of number of the voids and ratio of total volume of the voids (void content) are also calculated based on the above SEM photos and diameter of the voids obtained by the calculation. The more detailed calculation method of the diameter and so on will be described below.

As above, a sintered ceramics for mounting light-emitting element of the present invention having voids is described. In the sintered ceramics for mounting light-emitting element of the invention including filler for diffused reflection, diameter, distribution of diameter, and volume of the included filler for diffused reflection are also determined in the same manner.

In view of efficient light reflection, arithmetic average surface roughness (Ra) of the sintered ceramics for mounting light-emitting element of the invention is preferably $0.8\mu m$ or less.

< Method for manufacturing sintered ceramics for mounting light-emitting element > The sintered ceramics for mounting light-emitting element of the present invention can be fabricated by introducing the above-described voids existing inside the sintered ceramics or filler for diffused reflection. The method to introduce the voids or filler for diffused reflection is not particularly limited. For instance, when the sintered ceramics of the invention including the filler for diffused reflection is fabricated, ceramics powder, in which a predetermined dosage of filler for diffused reflection having a certain size distribution is added, may be simply sintered. At this time, as the filler for diffused reflection, a material to be selected may be the one of which refractive index is largely different from that of the ceramics powder, which is not melted at sintering point of the ceramics powder, and which does hardly react with the ceramics powder thereby almost maintain the particle shape itself.

When fabricating the sintered ceramics of the invention including the specific region having a certain voids at a predetermined ratio, by using reaction of ceramics, it can be preferably fabricated in accordance with the following method.

In other words, the sintered ceramics for mounting light-emitting element can be fabricated by a method having the steps of: preparing a raw sintered ceramics capable to react with reactive gas; and forming the specific region by reacting the raw sintered ceramics and the reactive gas, wherein the reaction of the raw sintered ceramics and the reactive gas is carried out under a condition such that a plurality of voids of which diameter is 100nm~2000nm are formed in the specific region and the voids are mutually independent.

From the view point of easiness of void generation and control of distribution of voids' diameter, lattice constant of crystal of raw sintered ceramics and of sintered ceramics constituting the specific region are preferably different, lattice constant of the sintered ceramics specifically constituting the specific region is desirably lager than that of the raw sintered ceramics.

When the raw sintered ceramics is transformed into another sintered ceramics constituting the specific region by reacting with reactive gas, if the reaction is carried out at a temperature where neither the raw ceramics nor the transformed other ceramics melt, the reaction is generally proceed in a direction from the surface to the depth. At this time, since reaction-interface is constrained, microscopic voids are generated so as to reduce stress generated by the volume change associated with development of the reaction. Size of the voids generated at this stage is affected by the reaction condition. Moreover, as ceramics constituting the produced specific region is not melted, these voids are fixed and remained inside the ceramics; the ceramics constituting the specific region have some extent of fluidity. Therefore, neighboring voids are adhered each other to grow or gas inside the ceramics is scattered depending on the heating condition (temperature and heating time), and distribution of the diameter is varied. Accordingly, number of the voids remained inside the sintered ceramics constituting the specific region eventually obtained and distribution of the void diameter can be controlled to some extent by controlling the reaction condition and the subsequent heat-treatment condition.

In general, size of void generated at the initial reaction stage tends to be smaller when the reaction is mildly proceeded; and size of the same tends to be lager when the reaction is rapidly proceeded. On the other hand, when the reaction is carried out at high temperature for a long period of time, number of smaller voids tends to be reduced and number of larger voids tends to be increased. "A condition for forming in the specific region a plurality of voids of which diameter is 100nm~2000nm and the voids are mutually independent" in the method for fabricating the present invention is an optimal reaction condition determined based on the above qualitative tendency.

Hereinafter, the method will be described in detail with reference to an example of fabrication of the sintered ceramics for mounting light-emitting element of the present invention having specific region containing $\alpha$-alumina obtained by using sintered aluminum nitride as a raw sintered body and reacting this with oxygen.

As the sintered aluminum nitride to be used as the raw sintered body, in accordance with a common technology, a material obtained by molding a mixture of aluminum nitride powder or aluminum nitride powder and sintering aides into a specific shape and sintering the compact may be suitably used. As the sintering aides, commonly known sintering aides, for example, alkaline earth metal oxide such as CaO, SrO, $Ca_3Al_2O_6$, and rare earth oxide such as $Y_2O_3$, $CeO_2$, $Ho_2O_3$, $Yb_2O_3$, $Gd_2O_3$, $Nb_2O_3$, $Sm_2O_3$, and $Dy_2O_3$, and so on are specifically used without limitation.

For instance, a sintered body obtained by the following procedure may be suitably used: aluminum nitride powder containing sintering aides as necessary is mixed with organic binder, dispersant, plasticizer, solvent, and the like to prepare molding slurry (or paste); the slurry is molded by molding means like doctor-blade method, extruding-forming method, injection molding method, and casting-molding; and the obtained compact is delipidated if required and then it is calcinated.

In the above method, sintered aluminum nitride thus prepared and oxygen are reacted to reform aluminum nitride into $\alpha$-alumina. In such a circumstance, the sintered ceramics for mounting light-emitting element of the invention can be obtained under a condition that: a plurality of voids of which diameter is in the range of 100nm~2000nm and those voids are mutually independent are remained in the produced $\alpha$-alumina phase; more preferably, about the voids eventually remain, ratio of number of the voids of less than 400nm in diameter to total number of the voids is in the range of 30~90%, and ratio of number of the voids of 400nm or more and less than 800nm in diameter to total number of the voids is preferably in the range of 10~70%.

Further, $\alpha$-alumina phase having the above certain voids at the predetermined ratio is preferably formed within the region formed from surface of at least one face to at least 15$\mu$m depth of the sintered ceramics for mounting light-emitting element of the invention. In the invention, the region where this $\alpha$-alumina phase having the above certain voids at the predetermined ratio is formed is named as specific region. Thickness of the $\alpha$-alumina phase is more preferably 20$\mu$m or more.

As mentioned above, the sintered ceramics for mounting light-emitting element of the invention has a light-reflective face of which reflectance to light in each wavelength in the range of 250nm~750nm is 70% or more; in order to obtain a submount showing higher brightness, the reflectance is preferably 75% or more.

So as to obtain such a sintered ceramics, adopting one of the two methods shown in the following (1) and (2) is suitable. By adopting these methods, it is capable to easily and surely fabricate the sintered ceramics of which reflectance is 75% or more.

(1) A method for fabricating sintered ceramics for mounting light-emitting element of the invention, the method comprising the steps of: preparing a sintered aluminum nitride; and heating the sintered aluminum nitride at a temperature of 1300˚C or more under atmosphere containing oxygen gas and of which dew point is set in the range of 0~15˚C, until the portion from the surface to at least 15$\mu$m depth or more of the sintered aluminum nitride is oxidized into alumina, and for a period of time or more which requires to oxidize the portion from the surface to at least 30$\mu$m depth of the sintered aluminum nitride into alumina when partial pressure of the oxygen gas is 0.21 atm.

(2) A method for fabricating sintered ceramics for mounting light-emitting element of the invention, the method comprising the steps of: preparing a sintered aluminum nitride containing at least one of sintering aides component; and heating the sintered aluminum nitride at a temperature of 1300˚C or more under atmosphere containing oxygen gas and of which dew point is set in the range of -70˚C or less, until the portion from the surface to at least 20$\mu$m depth of the sintered aluminum nitride is oxidized into alumina.

A technique to oxidize a sintered aluminum nitride is known as a method for surface treatment of aluminum nitride. However, the sintered ceramics for mounting light-emitting element of the present invention cannot be obtained by the oxidation treatment being carried out for such a purpose. As it were, the oxidation treatment is done just as a surface treatment of aluminum nitride; in order not to spoil the characteristics of the aluminum nitride having basically high-degree of thermal conductivity, thickness of the alumina to be formed is normally 10$\mu$m or less. If the oxidized layer becomes thicker, not only the degree of thermal conductivity becomes lower, but also time for oxidation under a normally adopted oxidation temperature (1200˚C or less) takes extremely longer. Meanwhile, so as to form voids having the above distribution of the diameter and to surely obtain high-optical reflectance as high as 75% or more, it is necessary to form an oxidized layer having thickness of at least 15$\mu$m; so as to raise the certainty more, the thickness must be 20$\mu$m or more.

If thickness of the oxidized layer too thin, due to the effect of the sintered ceramics as a foundation, high optical reflectance cannot be obtained. In addition, since voids of larger diameter are hard to be generated, reflectance to light of long-wavelength region becomes lower.

In the method (1), oxidation is carried out at a temperature as high as 1300˚C or more. At a temperature less than 1300˚C, oxidation rate becomes slow, and also fluidity of the above-mentioned produced ceramics (alumina) is hardly happened; therefore, satisfactory voids cannot be formed, thereby favorable reflectance cannot be obtained. On the other hand, if temperature is too high, there is a possibility for aluminum nitride as a raw sintered body and produced alumina to be melted and broken down, further, there is a possibility to have a problem in durability of heating furnace. Thus, the temperature is preferably 1900˚C or less, more preferably 1750˚C or less, and particularly preferably 1600˚C or less.

Moreover, in this method, when partial pressure of oxygen gas is 0.21 atm, as long time as a period for heating the region from the surface to 30$\mu$m depth of the sintered aluminum nitride is required. In other words, oxidation under relatively watery atmosphere by which dew point is 0~15˚C, oxidation rate is faster than that of below-described method (2). So, for example, in the a period for oxidizing from a surface to 15$\mu$m depth of the sintered aluminum nitride under a condition of oxygen-gas partial pressure being 0.21 atm, time for the produced ceramics (alumina) to flow to form voids runs out, thereby it is still impossible to obtain favorable reflectance. In order to enhance the probability to obtain favorable reflectance, the sintered aluminum nitride is preferably heated for as long time as a period for heating the region from the surface to 50$\mu$m depth of the sintered aluminum nitride. The oxidation time is about five hours or more, preferably ten hours or more. Also, the upper limit thereof is not necessarily specified, it is usually 300 hours or less, in many cases, 200 hours or less is enough.

The lower the partial pressure of the oxygen-gas is, the slower the oxidation rate becomes. On the other hand, the higher the pressure of the oxygen-gas is, the faster the oxidation rate becomes. Consequently, if the invention is fabricated in accordance with the method (1), under the atmosphere of which oxygen-gas partial pressure is higher than 0.21 atm, thickness of alumina phase produced by the oxidation is required to be $30\mu$m or more; meanwhile, under the atmosphere of which oxygen-gas partial pressure is lower than 0.21 atm, even if the thickness of the above alumina phase is less than $30\mu$m, it is capable to obtain favorable reflectance. The thickness of the above alumina phase is a value as the thickness of the same measured after cooling the produced alumina phase.

In the atmosphere at a time when the sintered aluminum nitride as a raw sintered body is heated to oxidize the surface, at least oxygen gas may be included at a concentration capable to oxidize the surface; if the concentration is low, it takes long time before completing the oxidation of $15\mu$m or more thick sintered aluminum nitride. Therefore, the concentration of oxygen-gas in the atmosphere is preferably 0.001 atm or more, and more preferably 0.01 atm or more. In normal air, oxygen-gas partial pressure is 0.21 atm. Accordingly, since there is no need to adjust the oxygen-gas partial pressure, method (1) should be carried out in normal air. The period for oxidation is preferably time for producing alumina phase of $30\mu$m or more in thickness by this oxidation; so as to enhance the probability to obtain reflectance, it is most preferably a time for producing alumina phase of $50\mu$m or more in thickness.

Further, as described above, by this method (1), as oxidation rate is fast, it is easy to oxidize even to the center of aluminum nitride of the raw sintered body. Hence, this method is suitable for fabricating the sintered ceramics of which entire area is formed by the specific region containing $\alpha$-alumina as a main component.

In both of the method (1) and below-described method (2), oxidized layer of the sintered ceramics obtained after end of heating is formed by $\alpha$-alumina as the main component.

Next, the method (2) will be described as follows. In the method (2), in order to surely obtain 75% or more of reflectance, thickness of the oxidized layer is set to $20\mu$m or more. Even if the thickness is less than $20\mu$m, sometimes, it is possible to obtain reflectance of 75% or more as long as the oxidized layer has thickness of at least $15\mu$m or more; however, the probability is low. This might deteriorate yield of industrial productivity, so thickness of the oxidized layer is set to $20\mu$m or more. Further, if it is set to $50\mu$m or more, it is capable to obtain 80% or more of reflectance of wavelength of 300~750nm.

In the method (2), heating is carried out under an atmosphere of which dew point is -70˚C or less. Under such a circumstance under dry atmosphere, the oxidation rate compared with that of the above method (1) is extremely slow, if heating is done for a period as long as aluminum nitride is oxidized up to thickness of $15\mu$m or more, time for the formed ceramics to flow is satisfactory secured. This heating time is depending on the heating temperature and oxygen-gas partial pressure, it is about 40 hours or more, preferably 80 hours or more.

Also, in the method (2), the reason for requiring heating at a temperature of 1300˚C or more is the same as that of method (1). As the upper limit of the heating temperature, same as in the method (1), it is preferably 1900˚C or less, more preferably 1750˚C or less, and furthermore preferably 1600˚C or less.

In order to obtain the sintered ceramics of the invention by the method (2), sintered aluminum nitride containing at least one sintering aides component must be used as raw sintered body. The reason for this is not revealed yet, however, as shown in below-described Comparative example, when sintered aluminum nitride which does not contain sintering aides component is used as the raw sintered body, even when oxidized layer (alumina phase) grows to be thicker, it does not generate satisfactory voids, which enables to obtain a sintered body having favorable reflectance. Meanwhile, by the above method (1), even if sintered aluminum nitride which does not contain the sintering aides component is used, it is capable to obtain a sintering body having favorable reflectance.

In order to obtain the sintered ceramics by the method (2), dosage of the sintering aides contained in the sintered aluminum nitride as the raw material, to total mass of the sintered aluminum nitride (100 mass %), is preferably 0.01~10 mass %, and more preferably 2~5 mass %.

In both of the method (1) and the method (2), except for controlling reaction temperature, reaction time, water contained in the atmosphere (dew point), and so on, the reaction can be carried out in a same manner as normal oxidation treatment. In the above method (2), examples of available reaction gas may be dry air, high-purity oxygen gas, and gas obtained by diluting high-purity oxygen gas with dry inert gas such as high-purity nitrogen gas.

After the reaction, the gradually cooled sintered ceramics is just taken out. If the entire raw sintered aluminum nitride is not oxidized, crack is sometimes caused in the oxidized layer during the cooling step; this tends to be caused more frequent than the case done by the method (1). Therefore, if whole the raw sintered aluminum nitride is not oxidized completely, namely, if some aluminum nitride phase is remained, adopting the method (2) is preferable. On the other hand, as mentioned above, the method (1) has an advantage that realizes fast oxidation rate. As a consequent, for completely oxidize the raw sintered aluminum nitride, The method (1) is preferably adopted.

The sintered ceramics obtained by oxidizing aluminum nitride from the surface in this way, as above, is excellent in optical reflectance. Further, because $\alpha$-alumina phase to be the light-reflecting layer and foundation layer thereof are both produced from the raw sintered aluminum nitride which is originally a single sintered body, the sintered ceramics is constituted by a light-reflecting layer which is excellent in adhesiveness thereby cannot be peeled by Tape Peeling Test.

In the above description, the method (1) being carried out under atmosphere of which dew point is 0~15˚C and the method (2) being carried out under atmosphere of which dew point is -70˚C or less are described. It is obvious that a person skilled in the art is able to set an adequate condition under other atmosphere having various water volume based on these methods (1) and (2).

In addition, as described above, distribution of the diameter of voids which remain in the sintered ceramics can be possibly controlled to some extent by heat treatment as the after-treatment. As described in the method (1), when oxygen-gas partial pressure is 0.21 atm, heating must be carried out until the thickness of the oxidized layer becomes 30$\mu$m. Namely, the heating of oxidized layer of which thickness is 15$\mu$m or more being carried out until the thickness grows up to 30$\mu$m can be regarded as after treatment. According to the studies by the present inventors, it is observed that forming of the oxidized layer is not only influenced by the reaction condition, but also influenced by the surface condition of the raw sintered body to a certain degree. So, reaction temperature and reaction time of the oxidation reaction slightly varied depending on the surface condition of the raw sintered body.

The sintered ceramics having oxidized layer thus fabricated can be used just as it is or by forming it into a specific shape. In the forming, as long as thickness of the oxidized layer is maintained to be 15$\mu$m or more, surface of the oxidized layer may be ground.

In the sintered ceramics for mounting light-emitting element of the invention, the reflectance to light of wavelength in the range of 250~750nm is as high as 70% or more. So, if the sintered ceramics for mounting light-emitting element of the invention or ceramics package for light-emitting element is used as at least a part of constituent material of the face where light emitted from elements is radiated (e.g., when the sintered body is a submount, the face is element mounting face; when the sintered body is ceramics package for light-emitting element, the face is element mounting face and/or wall without reflector), it is capable to raise brightness of the light-emitting element. When used in these usages, whole ceramics portion of the package may be constituted by the sintered ceramics for mounting light-emitting element of the invention, or a specific portion where light is desired to be reflected may be constituted by the sintered ceramics for mounting light-emitting element of the invention. As structures of the sintered ceramics for mounting light-emitting element and ceramics package for the light-emitting element themselves, there are specifically no difference from conventionally known material made of ceramics of this kind.

Example

Hereinafter, Examples and Comparative examples are described in detail; however, the present invention is not limited by these examples. Various properties evaluated in the Examples and Comparative examples were measured and determined in accordance with the following methods.

(1) Reflectance

A 60-diameter ($\varphi$60) integrating-sphere accessory device ("150-0902"; with barium sulfate application) was set to a spectrophotometer "U-3210" manufactured by Hitachi, Ltd., then diffuse reflectance to light of wavelength in the range of 250nm~800nm was measured in accordance with integrating sphere. As the reference substance (reflectance: 100%), aluminum oxide (sub-white-plate "210-0740" manufactured by Hitachi, Ltd.) was used. The measurement condition was set to Bandpass: 5nm, Response: Medium, and Scanning speed: 15nm/min.

(2) Tape Peeling Test

Test tape used for the Peeling Test was a 12mm width of cellophane adhesive tape ("CT-12" manufactured by Nichiban Co., Ltd.) specified by JIS Z1522. The test surface was lightly blown off dust and so on with dry air to be cleaned. On to the test surface, Tape Peeling Test was carried out in accordance with the following procedure based on the procedure specified as a tape test in JIS H8504 (1990) for "Methods of adhesion test for metallic coatings".

1. A test tape is adhered onto a test surface. When adhered, the tape is carefully pressed by fingers not to produce air bubbles on the adhered surface. It must be noted that the adhered area should be 10mm x 5mm or more, and 12mm x 10mm or less.
2. Apart from a remaining portion of 30~50mm in length where is not adhered to the test surface, the test tape is continuously pressed for about ten seconds.
3. The portion of tape where is not adhered in the above (1) is held and strongly pulled so as to become vertical, and the tape is peeled at once.
4. The adhesive surface of the peeled tape is visually observed. If there is no fouling can be observed, the evaluation is ◎ (very good) ; if the fouling is no more than three or less, and each of the occupying area is within 1mm x 1mm or less, the evaluation is ○ (good); if there are four to ten fouling, or any one of the occupying area is over 1mm x 1mm, and less than 2mm x 2mm, the evaluation is Δ (not bad); and if there are furthermore fouling exist, the evaluation is ✕ (bad). It must be noted that corner areas of the adhered body is excluded from the subject of evaluation.

The test pieces which were given ◎ or ○ in the above evaluation were judged as a piece having no layer to be peeled.

(3) Thickness of oxidized film (thickness of specific region)

A flaw is made by glass-cutter on a face opposite to the observation face of the test piece, after that, a tooth pick is placed under the flaw of the test piece and load was applied to both ends so as to break this test piece. The test piece after the breakage was coated with Pt in thickness of 10nm by sputter coater and the coated test piece was observed by scanning electron microscope (SEM) at a magnification which enables to see the entire oxidized film (specific region). Five pieces of oxidized film in one eyeshot was left in optional two eyeshot and the thickness was measured, then average thickness of the ten pieces was determined as that of the oxidized film (specific region). Normally, once the substrate is treated by thermal oxidation treatment, since oxidation proceeds from the surface of the substrate, oxidized film (specific region) on the broken face of the test piece is formed on the substrate's entire circumference. The thickness of oxidized film (specific region) defined in the present invention is thickness obtained by measuring one side out of four sides of cross-section of the test piece as an observation surface (side).

(4) Diameter of voids, ratio of number of the voids, and the void content

A test piece was cut by dicing machines, the cut test piece was embedded by resin and hardened, then the cut surface was ground in multiple steps. The final grinding is buffing using 0.05$\mu$m size of alumina abrasive grain; under observation with aide of optical microscope at 2500 times magnification, buffing was carried out until flaw by cut-and-grinding cannot be observed. After treatment by ultrasonic cleaning in pure water, the buffed test piece was further washed by ethanol and dried; finally, it was coated with Pt in thickness of 10nm by using sputter coater.
Almost entire area of the oxidized film was observed by SEM at 5000 times magnification. At this magnification, it was confirmed that no remarkable difference can be found in distribution of the voids and so on. Photo at this magnification was taken. The photographed area was 15.8$\mu$m x 23.7$\mu$m (total photographed area: 374$\mu$m$^2$). The photographing is done in the region from of 1$\mu$m to 16.8$\mu$m depth from the outer-most layer of the oxidized film.
A transparent film was placed on the SEM photo taken above, and ceramics defective portion, which was observed as voids, were traced. Later, the figure traced on the transparent film was analyzed by particulate analysis using image analysis system ("IP-1000PC" manufactured by Asahi Kasei Corporation) and the accessory application software ("A-zou kun") under a condition of brightness of particle: dark, method for binarization: automatic, outer-edge correction: four sides, plugging: required, area where small-figure is removed: 50nm. Portions which is detected as particle was regarded as void. Diameter of a circle having area equivalent to the area (S) of each void obtained by the analysis [=$\{(4 \times S)/\pi\}^{(1/2)}$] was calculated, and the diameter of the circle was regarded as that of void. Further, void content (ratio of the voids to total volume) and ratio of number of the voids in each diameter was calculated by the following method.
$$\text{Void content} = (\text{Total area of the voids of which diameter in the photographed range is } 100\text{nm}\sim2000\text{nm})/(\text{Photographed area})$$

$$\text{Ratio of number of the voids} = (\text{Number of the voids having predetermined diameter in the photographed range})/(\text{Total number of the voids of which diameter in the photographed range is } 100\text{nm}\sim2000\text{nm})$$

The area of denominator for calculating the void content includes the non-oxidized area even if thickness of the oxidized film is 16.8$\mu$m or less and there is non-oxidized area exists in the photographed range.
Raw aluminum nitride substrate used as a raw material for fabricating the sintered ceramics in each Examples and Comparative examples are produced in accordance with the following methods.

(1) S-1

In a ball mill, 100 parts by mass of aluminum nitride powder, 5.0 parts by mass of yttrium oxide, 1.0 parts by mass of tetraglycerin monoolate as a surfactant, 50 parts by mass of toluene as a solvent, 13 parts by mass of poly-n-butylmethacrylate as a binder, 4.2 parts by mass of dibutylphthalate as a plasticizer, and 5 parts by mass of butyl acetate were mixed to obtain white-color slip. Then, sheet-forming using the obtained slip was carried out by doctor-blade method, and green sheets for insulating board respectively having thickness of 0.6mm were produced. About the obtained green sheet, heat-delipidation was carried out at 850˚C for two hours under circulation of hydrogen-gas containing water at a rate of 10L/min. Rate of temperature increase at a time of delipidation was set to 2.5˚C/min. After delipidation, the delipidated body was fed into aluminum nitride-made container and heated in nitrogen atmosphere at 1800˚C for five hours to obtain a sintered body. The obtained sintered body was translucent grey in color tone. Also, the amount of remaining sintering aides was measured by ICP analysis method, it was $3.5 \pm 0.5$ mass %.

(2) S-2

In a ball mill, 100 parts by mass of aluminum nitride powder, 5.0 parts by mass of yttrium oxide, 0.5 parts by mass of tricalcium phosphate, 1.0 parts by mass of tetraglycerin monoolate as a surfactant, 50 parts by mass of toluene as a solvent, 13 parts by mass of poly-n-butylmethacrylate as a binder, 4.2 parts by mass of dibutylphthalate as a plasticizer, and 5 parts by mass of butyl acetate were mixed to obtain white-color slip. Then, sheet forming using the obtained slip was carried out by doctor-blade method, and green sheets for insulating board respectively having thickness of 0.6mm were produced. About the obtained green sheet, heat-delipidation was carried out at 570˚C for four hours in air. Rate of temperature increase at a time of delipidation was set to 2.5˚C/min. After delipidation, the delipidated body was fed into aluminum nitride-made container and heated in nitrogen atmosphere at 1860˚C for 50 hours, then it was washed by hydrochloric acid, and again, heated in nitrogen atmosphere at 1860˚C for 50 hours to obtain a sintered body. The obtained was translucent white in color tone. Also, the amount of remaining sintering aides was measured by ICP analysis method, it was 0.01~1.0 mass %.

(3) S-3

In a ball mill, 100 parts by mass of aluminum nitride powder, 1 parts by mass of tetraglycerin monoolate as a surfactant, 3 parts by mass of poly-n-butylmethacrylate as a binder, and 100 parts by mass of toluene as a solvent were mixed to obtain white-color slip. The slip thus obtained was granulated by spray-dryer method and aluminum nitride granules in a size of 70~100μm were produced. The granules were then formed into a pressed compact of which diameter is 40mm and thickness is 3.0mm by press-forming with a pressure of $0.3t/cm^2$ using predetermined shape of dies. Later, in the atmosphere, the temperature was raised at a rate of 0.2˚C/min, the pressed compact was calcinated at 600˚C for eight hours. The calcinated compact was fed into a carbon-made vase of which inside was applied by boron nitride and then calcinated in nitrogen atmosphere at 1810˚C for six hours to obtain a sintered body.
Each aluminum nitride board were provided, just as sintered body is (as-fired), to each Example and Comparative example by adjusting the center-line mean deviation of the profile by mirror polishing to become Ra $\leqq$ 0.05μm, or adjusting the center-line mean deviation of the profile by lapping-polishing to become Ra $\leqq$ 0.8μm.

(Example 1)

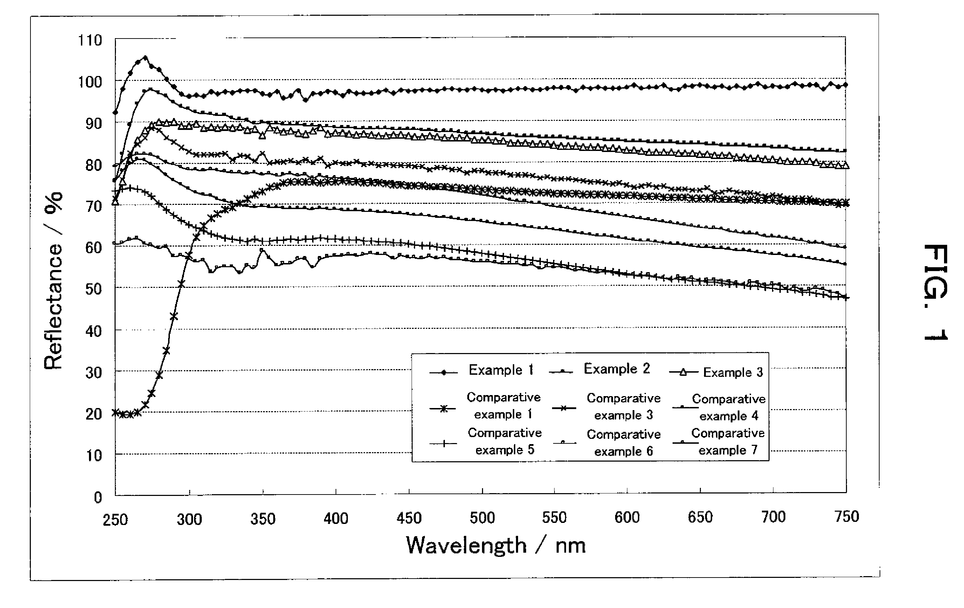

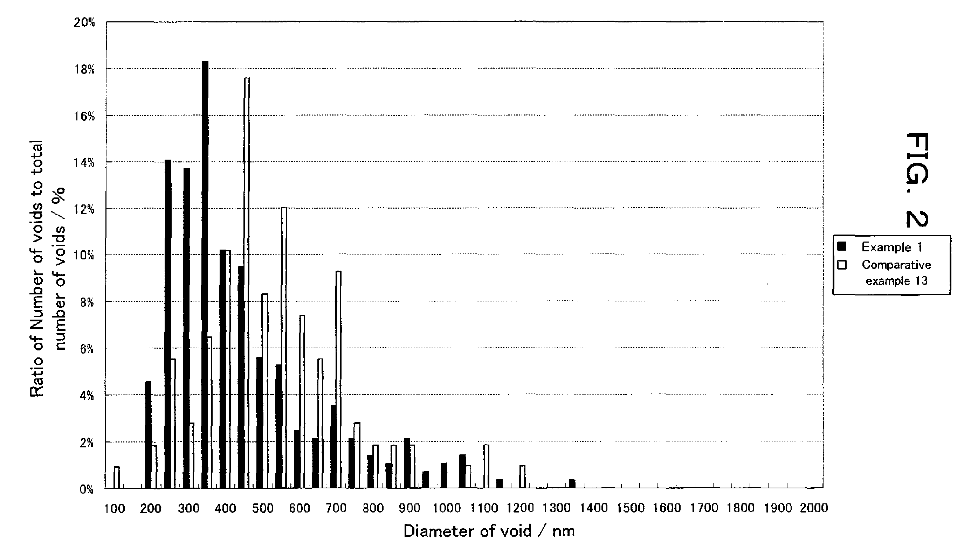

The aluminum nitride board S-1 fabricated to become about 0. 6mm in thickness at the end of calcinations was fed into a vacuum heating furnace just as the sintered body is. The pressure in the furnace was vacuumed down to 0.01Pa or less; thereafter, high-purity nitrogen-gas of which dew point is -70˚C or less was introduced into the furnace so as the pressure to be normal pressure. Under this atmosphere, temperature was raised up to 1400˚C at a rate of 200˚C/hr.
When the temperature became 1400˚C, the sintered body was heated for 144 hours under circulation of dry air of which dew point -70˚C or less at a rate of 0.5L/min. The obtained sintered body taken out from the furnace, in which temperature was decreased to the room temperature, was white in color-tone.
The measurement result of reflectance is shown in Table 1 and FIG. 1. As seen from these, reflectance in all wavelength in the range of 250~750nm was 90% or more. When this sintered body was analyzed by powder X-ray diffraction method, peak about aluminum nitride was not detected, but only peaks about α-alumina and yttrium aluminate were detected. In other words, aluminum nitride was reformed into α-alumina, and the α-alumina layer reached the center portion, no aluminum nitride was remained.
When the cross-section was observed by SEM, many voids were observed. Relation of diameter of the voids and ratio of number of the voids in each diameter is shown in FIG. 2. Ratio of number of the voids of which diameter is less than 400nm was calculated to be 61%, and ratio of number of the voids of which diameter is 400nm or more and less than 800nm was calculated to be 32%. The void content was 13%. Together with this, as a comparison, ratio of the voids in each diameter of below-described Comparative example 13 is shown in FIG. 2. In Comparative example 13, it can be found out that ratio of number of the voids, of which diameter is less than 400nm, is small.

(Comparative example 1)

Reflectance about 99.5% aluminum oxide ($Al_2O_3$) board fabricated by CoorsTek, Inc. was measured. The result is shown in Table 1 and FIG. 1. Also, the cross-section was measured by SEM, voids were not substantially observed.

(Comparative example 2)

Tape Peeling Test was carried out to the same aluminum oxide white-plate as the reference test piece used for surface reflectance measurement, white powder was adhered all over the tape's adhesive surface.

(Examples 2, 3 and Comparative examples 3~7)

Except for changing the oxidation temperature (maximum temperature at a time of heating) and oxidation time (period of maximum temperature to be kept) to the condition shown in Table 1, Examples 2, 3 and Comparative examples 3~7 were carried out in the same manner as Example 1 to obtain oxidized test piece. Together with this, evaluation results of the various properties are also shown in Table 1. Further, in FIG. 1, reflectance data in each wavelength of Examples 1~3 and Comparative examples 1~7 are shown.
(Table 1)

(Table 1)

| | AlN thickness (mm) | Oxdation temperature (˚C) | Oxidation time (hr) | Atmosphere | | Oxidized film thickness (μm) | Reflectance (%) | | | Tape peeling test | Ratio of Number of voids | | Void content |
| --- | --- | --- | --- | --- | --- | --- | --- | --- | --- | --- | --- | --- | --- |
| | | | | Dew point | O₂partial pressure (atm) | | 750nm | 300nm | 250nm | | <400nm | 400-800nm | |
| Example 1 | 0.6 | 1400 | 144 | ≦-70˚C | 0.21 atm | All | 98.5 | 96.3 | 92.3 | ◎ | 61% | 32% | 13% |
| Example 2 | 0.6 | 1350 | 150 | ≦-70˚C | 0.21 atm | 60 | 82.2 | 93.0 | 75.6 | ◎ | 38% | 61% | 8% |
| Example 3 | 0.6 | 1350 | 100 | ≦-70˚C | 0.21 atm | 45 | 78.9 | 89.0 | 70.8 | ◎ | - | - | - |
| Comparative example 1 | Commercially-available alumina | | | | | | 69.7 | 57.5 | 18.4 | ◎ | ~0 | ~0 | ~0 |
| Comparative example 3 | 0.6 | 1350 | 30 | ≦-70˚C | 0.21 atm | 19 | 69.4 | 82.8 | 71.4 | ◎ | - | - | - |
| Comparative example 4 | 0.6 | 1350 | 15 | ≦-70˚C | 0.21 atm | 13 | 55.0 | 73.7 | 75.9 | ◎ | - | - | - |
| Comparative example 5 | 0.6 | 1300 | 100 | ≦-70˚C | 0.21 atm | 5 | 46.8 | 65.1 | 73.3 | ◎ | - | - | - |
| Comparative example 6 | 0.6 | 1250 | 100 | ≦-70˚C | 0.21atm | 4 | 46.9 | 57.0 | 60.4 | ◎ | - | - | - |
| Comparative example 7 | 0.6 | 1350 | 75 | ≦-70˚C | ~0 | 3 | 59.1 | 78.5 | 79.4 | ◎ | - | - | - |

EP 1 930 305 A1

(Example 4)

Except for treating the aluminum nitride board S-1 by mirror polishing until the thickness becoming 0.4mm, Example 4 was carried out in the same manner as Example 1 to obtain an oxidized test piece.
The evaluation results of the various properties are shown in Table 2.

(Example 5, Comparative examples 8~11)

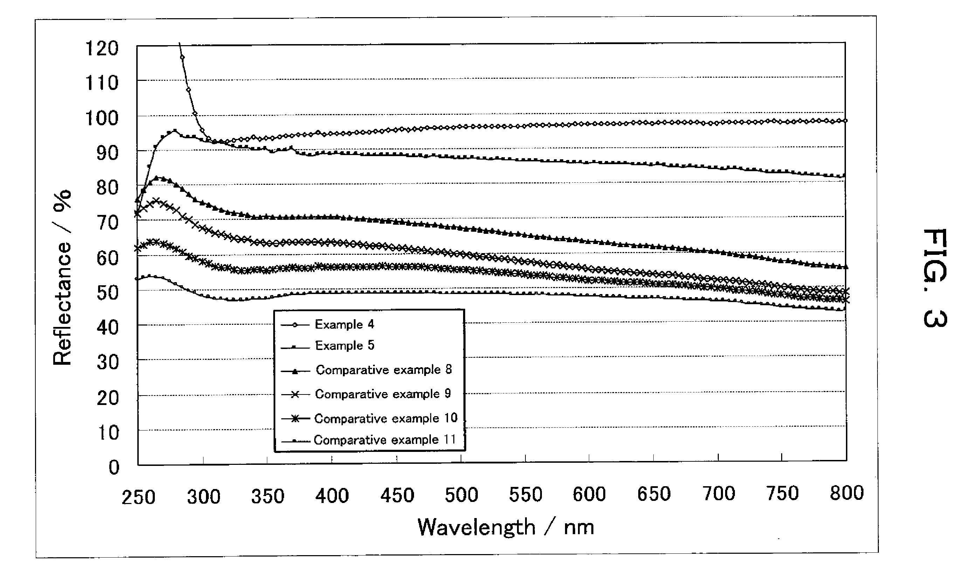

Except for changing the oxidation temperature (maximum temperature at a time of heating) and oxidation time (period of maximum temperature to be kept) to the condition shown in Table 2, Example 5 and Comparative examples 8~11 were carried out in the same manner as Example 4 to obtain oxidized test pieces.
The evaluation results of the various properties are shown in Table 2. Also, in FIG. 3, reflectance data in each wavelength of Examples 4 and 5 and Comparative examples 8~11 are shown.
(Table 2)

(Table 2)

| | AIN thickness (mm) | Oxdation temperature (˚C) | Oxidation time (hr) | Atmosphere | | Oxidized film thickness ($\mu$m) | Reflectance (%) | | | Tape peeling test | Ratio of Number of voids | | Void content |
|---|---|---|---|---|---|---|---|---|---|---|---|---|---|
| | | | | Dew point | $O_2$ partial pressure (atm) | | 750nm | 300nm | 250nm | | <400nm | 400-800nm | |
| Example 4 | 0.4 | 1400 | 144 | ≦-70˚C | 0.21 atm | All | 97.1 | 95.6 | 135.6 | ◎ | - | - | - |
| Example 5 | 0.4 | 1350 | 100 | ≦-70˚C | 0.21 atm | 52 | 82.7 | 92.5 | 72.0 | ◎ | 60% | 36% | 14% |
| Comparative example 8 | 0.4 | 1350 | 15 | ≦-70˚C | 0.21 atm | 9 | 57.6 | 75.0 | 75.9 | ◎ | | | - |
| Comparative example 9 | 0.4 | 1300 | 25 | ≦-70˚C | 0.21 atm | 12 | 49.8 | 67.7 | 71.8 | ◎ | - | - | - |
| Comparative example 10 | 0.4 | 1300 | 5 | ≦-70˚C | 0.21 atm | 6 | 47.7 | 58.0 | 62.1 | ◎ | - | - | - |
| Comparative example 11 | 0.4 | 1200 | 71 | ≦-70˚C | 0.21 atm | 5 | 44.3 | 48.2 | 52.9 | ◎ | - | - | - |

EP 1 930 305 A1

(Example 6)

Except for treating the aluminum nitride board S-2 by mirror polishing and for setting the oxidation temperature to be 1350°C and oxidation time to be 50 hours, Example 6 was carried out in the same manner as Example 1 to obtain an oxidized test piece. The evaluation results of the various properties are shown in Table 3.

(Comparative example 12)

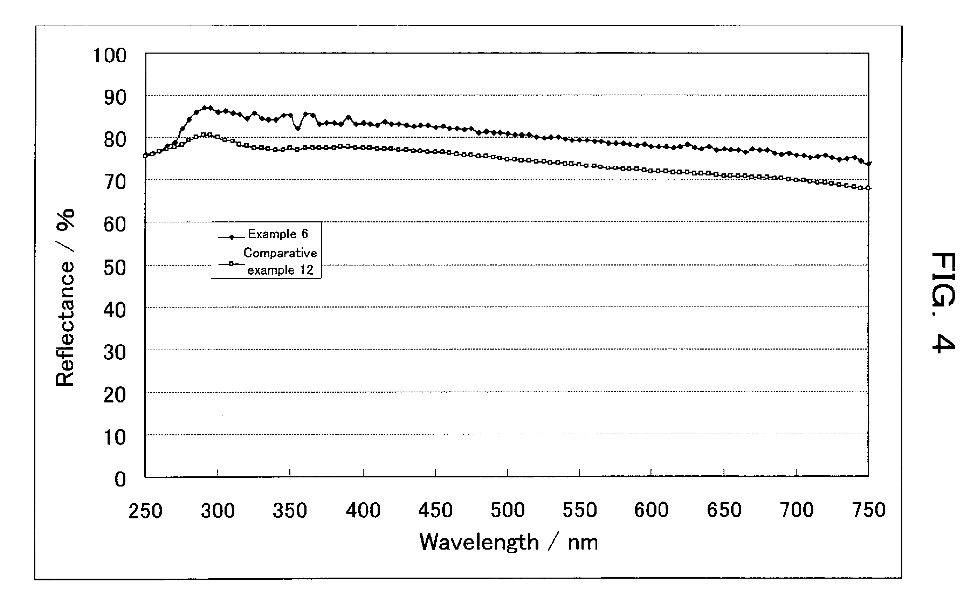

Except for setting the oxidation temperature to be 1300°C and oxidation time to be 15 hours, Comparative example 12 was carried out in the same manner as Example 6. The evaluation results of the various properties are shown in Table 3. Also, in FIG. 4, reflectance data in each wavelength of Example 6 and Comparative example 12 are shown.

(Table 3)

| | AIN thickness (mm) | Oxdation temperature (˚C) | Oxidation time (hr) | Atmosphere | | Oxidized film thickness (μm) | Reflectance (%) | | | Tape peeling test | Ratio of Number of voids | | Void content |
|---|---|---|---|---|---|---|---|---|---|---|---|---|---|
| | | | | Dew point | O$_2$partial pressure (atm) | | 750nm | 300nm | 250nm | | <400nm | 400-800nm | |
| Example 6 | 0.4 | 1350 | 50 | ≦-70˚C | 0.21atm | 17 | 73.7 | 85.8 | 76.0 | ◎ | - | - | - |
| Comparative example 12 | 0.4 | 1300 | 15 | ≦-70˚C | 0.21atm | 9 | 68.0 | 80.0 | 74.4 | ◎ | - | - | - |

EP 1 930 305 A1

(Comparative examples 13~19)

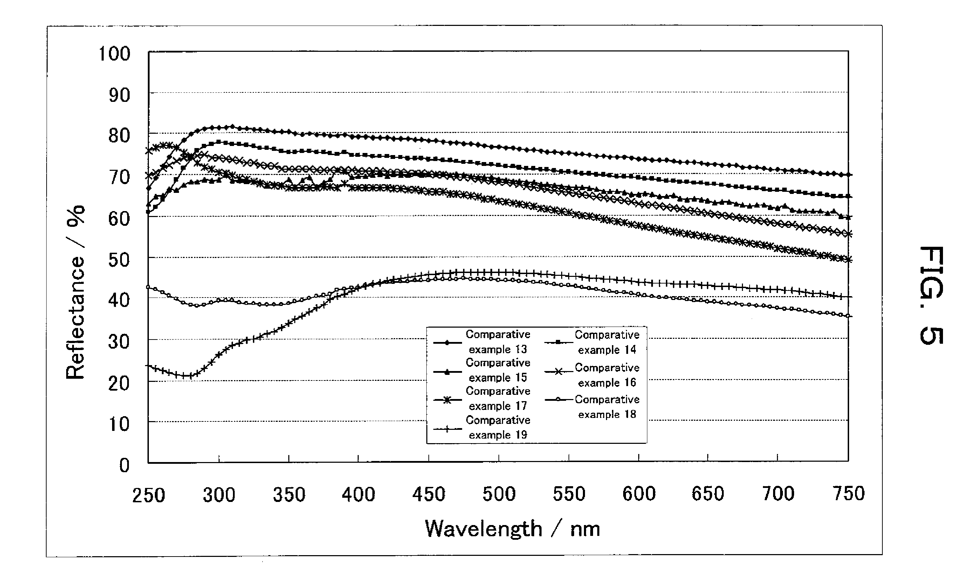

Except for using the aluminum nitride board S-3 treated by mirror polishing to make it 0.4mm in thickness and for setting the oxidation temperature and oxidation time to be the same temperature and time shown in Table 4, Comparative examples 13~19 were carried out in the same manner as Example 1 to obtain oxidized test pieces. The evaluation results of the various properties are shown in Table 4. Also, in FIG. 5, reflectance data in each wavelength of Comparative examples 13~19 are shown.

(Table 4)

| | AlN thickness (mm) | Oxdation temperature (˚C) | Oxidation time (hr) | Atmosphere | | Oxidized film thickness (μm) | Reflectance (%) | | | Tape peeling test | Ratio of Number of voids | | Void content |
|---|---|---|---|---|---|---|---|---|---|---|---|---|---|
| | | | | Dew point | O$_2$partial pressure (atm) | | 750nm | 300nm | 250nm | | <400nm | 400-800nm | |
| Comparative example 13 | 0.4 | 1350 | 200 | ≦-70˚C | 0.21 atm | 51 | 69.7 | 81.4 | 66.8 | ◎ | 27% | 65% | 6% |
| Comparative example 14 | 0.4 | 1350 | 150 | ≦-70˚C | 0.21 atm | 37 | 64.4 | 77.7 | 61.0 | ◎ | - | - | - |
| Comparative example 15 | 0.4 | 1350 | 50 | ≦-70˚C | 0.21 atm | 18 | 59.5 | 68.8 | 63.0 | ◎ | - | - | - |
| Comparative example 16 | 0.4 | 1250 | 100 | ≦-70˚C | 0.21 atm | 11 | 55.5 | 74.0 | 69.9 | ◎ | - | - | - |
| Comparative example 17 | 0.4 | 1250 | 50 | ≦-70˚C | 0.21 atm | 10 | 49.2 | 70.6 | 75.8 | ◎ | - | - | - |
| Comparative example 18 | 0.4 | 1200 | 20 | ≦-70˚C | 0.21 atm | 4 | 35.4 | 39.1 | 43.0 | ◎ | - | - | - |
| Comparative example 19 | 0.4 | 1200 | 5 | ≦-70˚C | 0.21 atm | 2 | 40.0 | 26.3 | 23.6 | ◎ | - | - | - |

(Table 4)

EP 1 930 305 A1

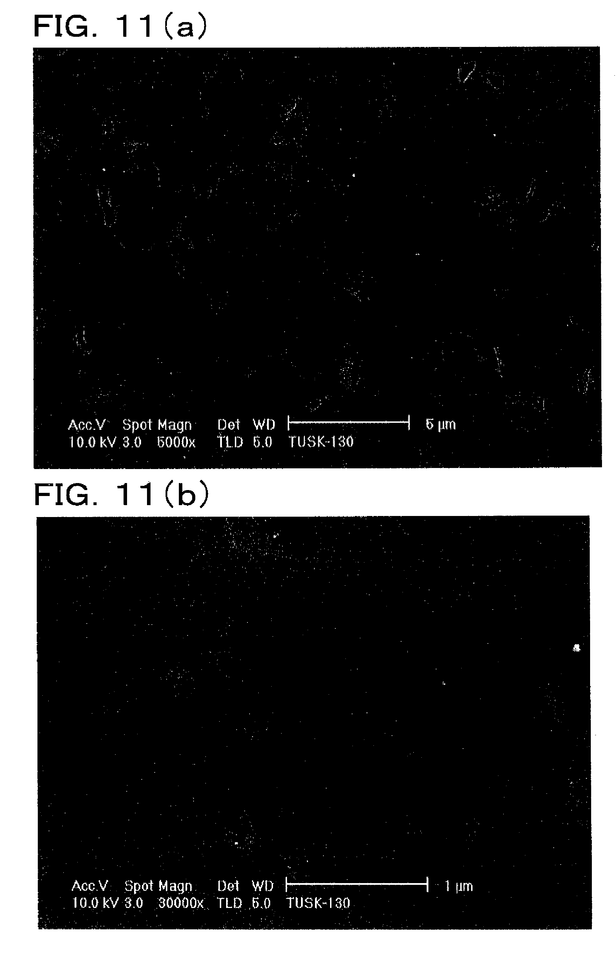

S-3 is a sintered aluminum nitride wherein a sintering aides was not used during the fabrication, when heating (oxidizing) such a sintered aluminum nitride as a test piece under an atmosphere of which dew point is -70°C or less, satisfactory reflectance cannot be obtained even if thickness of oxidized film become thicker. According to the observation about the cross-section of oxidized layer ($\alpha$-alumina) of Comparative example 13 by SEM, compared with Example sample, number of voids (void content) existing in the oxidized layer was small. The SEM photo about cross-section of oxidized layer of Comparative example 13 is shown in FIG. 11 (a) (5000 magnification) and FIG. 11(b) (30000 magnification).

(Example 7)

The aluminum nitride board S-1 treated by mirror polishing to make it 0.4mm in thickness was fed into a heating furnace which does not have atmosphere-control function. Under this atmosphere, the above board was heated under a condition where the temperature was raised up to be 1350°C at a temperature-increasing ratio of 200°C/hr, the temperature was kept for 80 hours, then it was lowered to room temperature to take the sample out from the furnace. The above furnace which does not have the atmosphere-control function was set up in a room of which degree of humidity is adjusted to become 0~15°C in dew point. Consequently, dew point of the atmosphere installed in the heating furnace was in the range of 0~15°C. The measured results of the various properties are shown in Table 5.

(Examples 8 and 9, and Comparative examples 20 and 21)

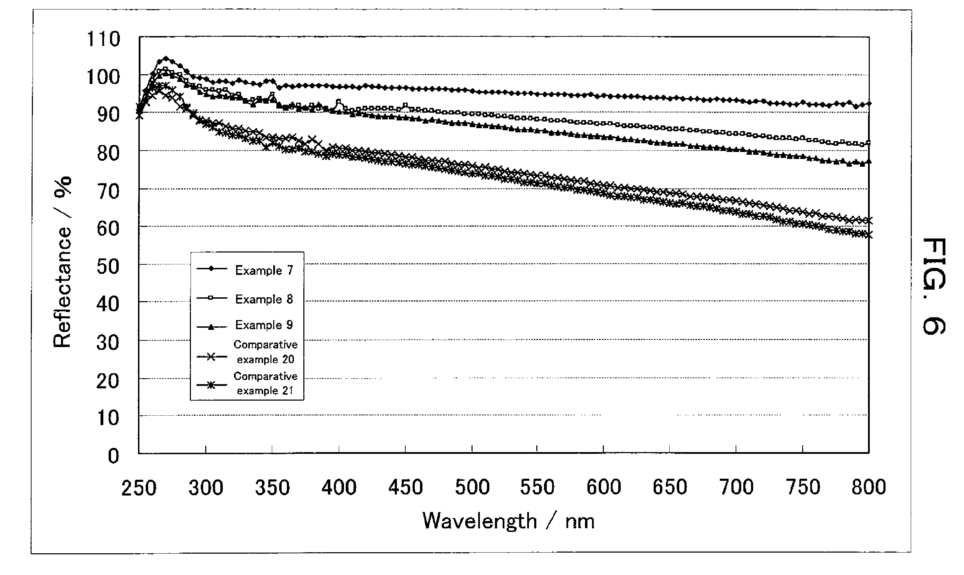

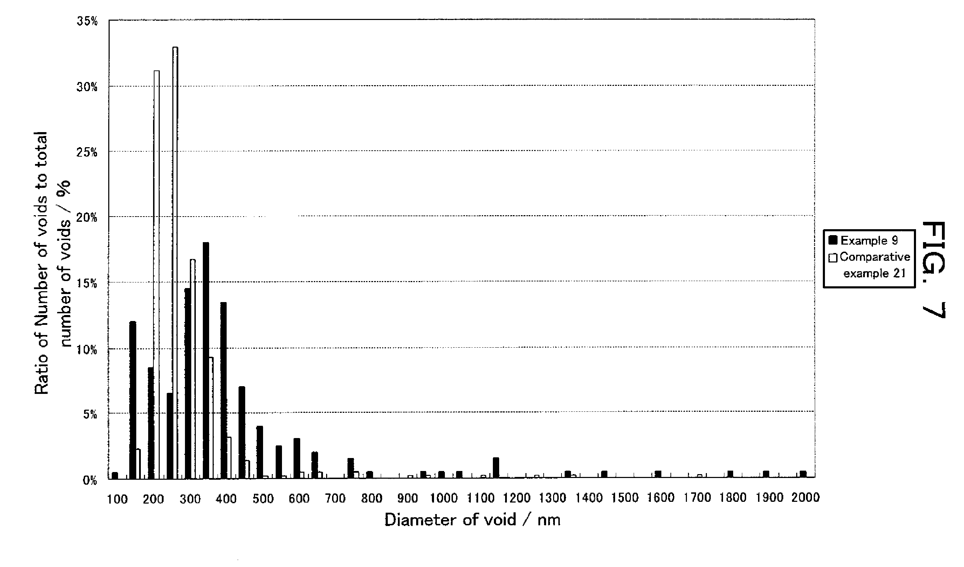

Except for changing the oxidation temperature and oxidation time to the same temperature and time shown in Table 5, Examples 8 and 9, and Comparative examples 20 and 21 were carried out in the same manner as Example 7 to obtain oxidized test pieces.
The evaluation results of the various properties are shown in Table 5. Also, in FIG. 6, reflectance data in each wavelength of Examples 7~9, and Comparative examples 20 and 21 are shown. In addition, in FIG. 7, ratio of number of the voids in each diameter about Example 9 and Comparative example 21 are shown. As seen from FIG. 7, in Comparative example 21, it is understood that distribution of the voids deviates to smaller diameter of the voids.
(Table 5)

| | AIN thickness (mm) | Oxdation temperature (˚C) | Oxidation time (hr) | Atmosphere | | Oxidized film thickness ($\mu$m) | Reflectance (%) | | | Tape peeling test | Ratio of Number of voids | | Void content |
|---|---|---|---|---|---|---|---|---|---|---|---|---|---|
| | | | | Dew point | $O_2$ partial pressure (atm) | | 750nm | 300nm | 250nm | | <400nm | 400-800nm | |
| Example 7 | 0.4 | 1350 | 80 | 0~15˚C | 0.21atm | 96 | 92.8 | 98.8 | 91.6 | ◎ | - | - | - |
| Example 8 | 0.4 | 1330 | 10 | 0~15˚C | 0.21atm | 42 | 83.1 | 95.8 | 90.1 | ◎ | - | - | - |
| Example 9 | 0.4 | 1300 | 5 | 0~15˚ | 0.21atm | 34 | 78.6 | 94.7 | 90.3 | ◎ | 73% | 21% | 9% |
| Comparative example 20 | 0.4 | 1300 | 1 | 0~15˚ | 0.21atm | 15 | 63.8 | 87.7 | 89.3 | ◎ | - | - | - |
| Comparative example 21 | 0.4 | 1200 | 15 | 0~15˚C | 0.21atm | 15 | 60.7 | 87.0 | 91.4 | ◎ | 95% | 3% | 8% |

(Examples 10~12 and Comparative examples 22~27)

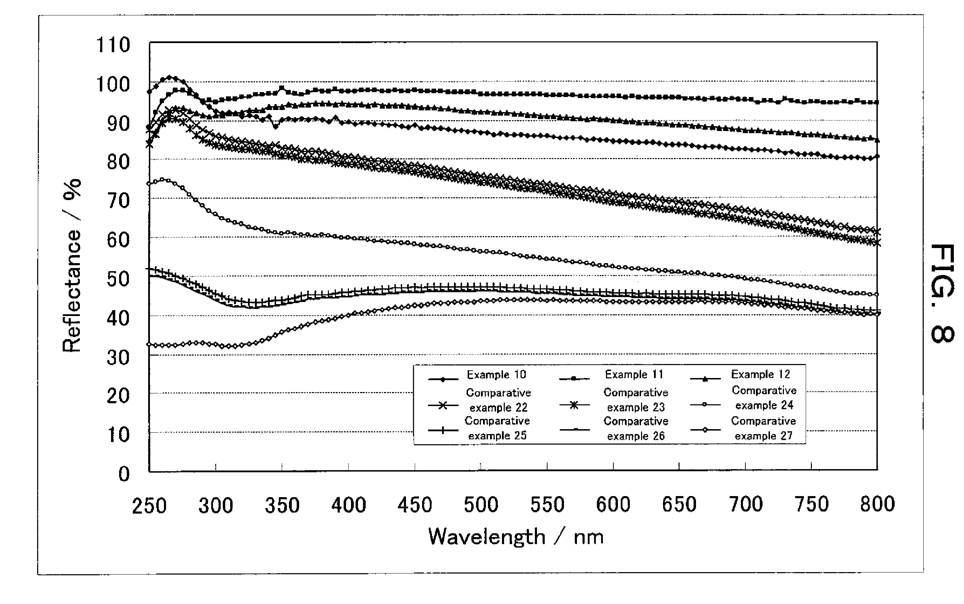

Except for using the aluminum nitride board S-1 treated by mirror polishing to become a thickness shown in Table 6 and for changing the oxidation temperature and oxidation time to the same temperature and time shown in Table 6, Examples 10~12 and Comparative examples 22~27 were carried out in the same manner as Example 7. The evaluation results of the various properties are shown in Table 6. Also, in FIG. 8, reflectance data in each wavelength of Examples 10~12 and Comparative examples 22~27 are shown.
(Table 6)

| | AlN thickness (mm) | Oxdation temperature (°C) | Oxidation time (hr) | Atmosphere | | Oxidized film thickness (μm) | Reflectance (%) | | | Tape peeling test | Ratio of Number of voids | | Void content |
|---|---|---|---|---|---|---|---|---|---|---|---|---|---|
| | | | | Dew point | O$_2$ partial pressure (atm) | | 750nm | 300nm | 250nm | | <400nm | 400-800nm | |
| Example 10 | 0.4 | 1350 | 150 | 0~15°C | 0.21atm | Not measured | 81.2 | 92.5 | 97.4 | ◎ | - | - | - |
| Example 11 | 0.5 | 1350 | 80 | 0~15°C | 0.21atm | 96 | 94.7 | 94.6 | 88.3 | ◎ | - | - | - |
| Example 12 | 0.5 | 1350 | 15 | 0~15°C | 0.21atm | 34 | 86.3 | 91.2 | 84.9 | ◎ | 77% | 18% | 14% |
| Comparative example 22 | 0.5 | 1300 | 1 | 0~15°C | 0.21atm | Not measured | 64.0 | 86.1 | 87.6 | ◎ | - | - | - |
| Comparative example 23 | 0.5 | 1200 | 15 | 0~15°C | 0.21atm | Not measured | 61.1 | 83.7 | 84.0 | ◎ | - | - | - |
| Comparative example 24 | 0.5 | 1200 | 50 | 0~15°C | 0.21atm | Not measured | 46.9 | 65.8 | 73.6 | ◎ | - | - | - |
| Comparative example 25 | 0.5 | 1200 | 1 | 0~15°C | 0.21atm | Not measured | 42.7 | 45.5 | 51.8 | ◎ | - | - | - |
| Comparative example 26 | 0.5 | 1100 | 15 | 0~15°C | 0.21atm | Not measured | 41.6 | 43.9 | 50.0 | ◎ | - | - | - |
| Comparative example 27 | 0.5 | 1100 | 5 | 0~15°C | 0.21atm | Not measured | 41.3 | 32.5 | 32.6 | ◎ | - | - | - |

(Examples 13~15 and Comparative examples 28~32)

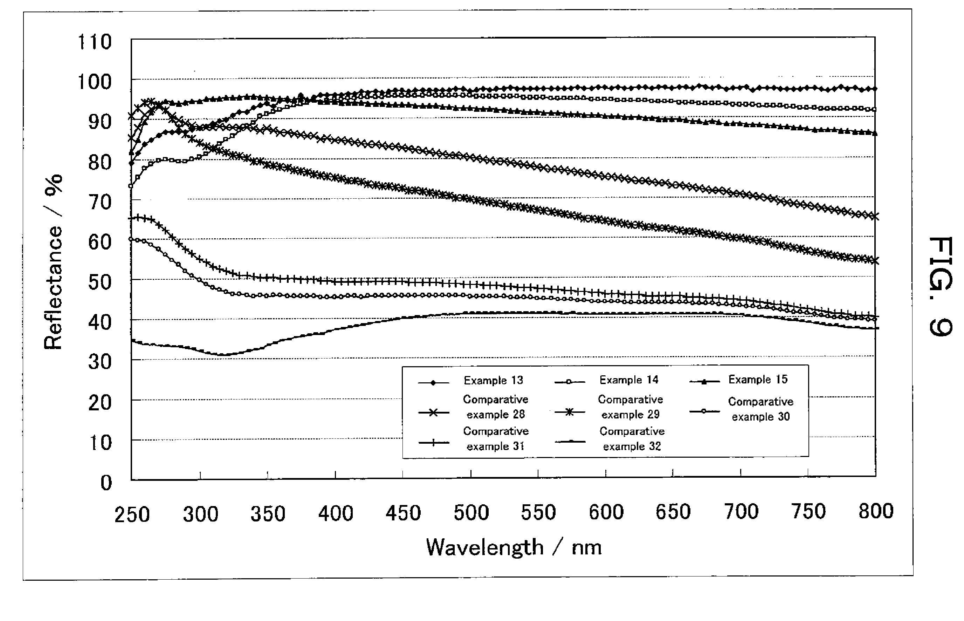

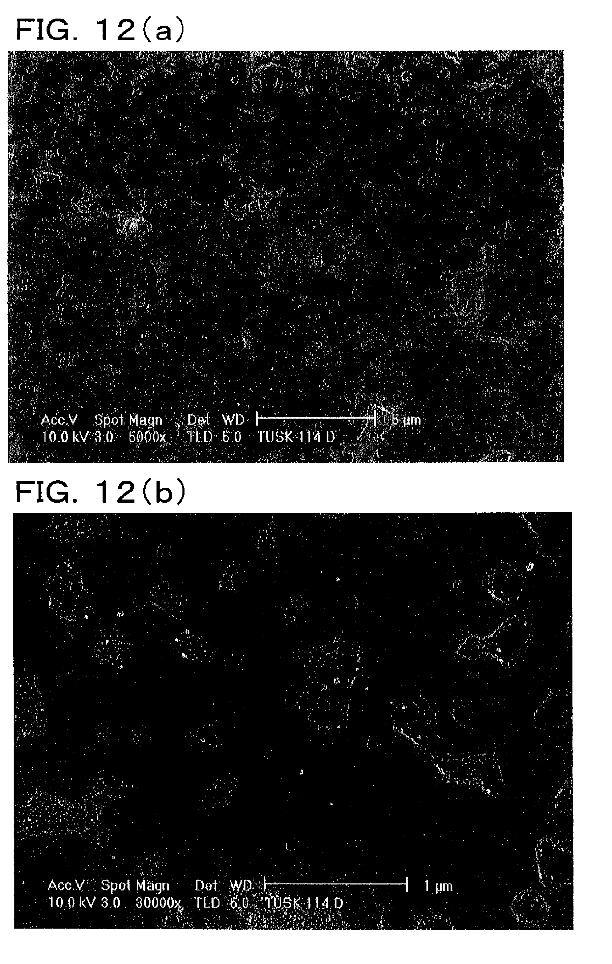

Except for using a 0.6mm thick S-1, as an aluminum nitride board which was left as it was and was not ground, and for changing the oxidation temperature and oxidation time to the same temperature and time shown in Table 7, Examples 13~15 and Comparative examples 28~32 were conducted in the same manner as Example 7.
The evaluation results of the various properties are shown in Table 7. Also, in FIG. 9, reflectance data in each wavelength of Examples 13~15, Comparative examples 28~32 are shown. Further, the SEM photo about cross-section of oxidized layer of Comparative example 13 is shown in FIG. 12 (a) (5000 magnification) and FIG. 12(b) (30000 magnification). Compared with the SEM photo of Comparative example 13 shown in FIGs. 11(a) and 11(b), number of the voids shown in FIGs. 12 (a) and 12 (b) are obviously larger than that shown in FIGs. 11 (a) and 11 (b) . Further, Example 13, there are voids with the wide range of size from a small diameter to a large diameter.
In Japanese Patent Application No. 2005-277048, after cutting and grinding, the surface layer was treated by focused ion beam (FIB) process; in each Examples and Comparative examples in this application, observation and photographing were carried out without conducting the FIB process. Therefore, in these photos, the voids are clogged with abrasive grain for grinding.
(Table 7)

| | AlN thickness (mm) | Oxdation temperature (˚C) | Oxidation time (hr) | Atmosphere | | Oxidized film thickness (μm) | Reflectance (%) | | | Tape peeling test | Ratio of Number of voids | | Void content |
|---|---|---|---|---|---|---|---|---|---|---|---|---|---|
| | | | | Dew point | O₂ partial pressure (atm) | | 750nm | 300nm | 250nm | | <400nm | 400-800nm | |
| Example 13 | 0.6 | 1350 | 80 | 0~15˚C | 0.21 atm | 91 | 97.3 | 87.7 | 79.2 | ◎ | 49% | 48% | 16% |
| Example 14 | 0.6 | 1350 | 15 | 0~15˚C | 0.21 atm | 82 | 92.4 | 80.4 | 73.2 | ◎ | - | - | - |
| Example 15 | 0.6 | 1300 | 5 | 0~15˚C | 0.21 atm | 49 | 87.1 | 94.5 | 81.9 | ◎ | - | - | - |
| Comparative example 28 | 0.6 | 1200 | 15 | 0~15˚C | 0.21 atm | 28 | 67.7 | 88.0 | 85.4 | ◎ | - | - | - |
| Comparative example 29 | 0.6 | 1200 | 5 | 0~15˚C | 0.21 atm | 12 | 49.7 | 76.1 | 84.1 | ◎ | - | - | - |
| Comparative example 30 | 0.6 | 1200 | 1 | 0~15˚C | 0.21 atm | 4 | 40.8 | 49.9 | 60.1 | ◎ | - | - | - |
| Comparative example 31 | 0.6 | 1100 | 15 | 0~15˚C | 0.21 atm | 4 | 42.0 | 55.1 | 65.1 | ◎ | - | - | - |
| Comparative example 32 | 0.6 | 1100 | 5 | 0~15˚C | 0.21atm | 2 | 38.6 | 32.0 | 34.8 | ◎ | - | - | - |

EP 1 930 305 A1

(Examples 16~18 and Comparative examples 33~38)

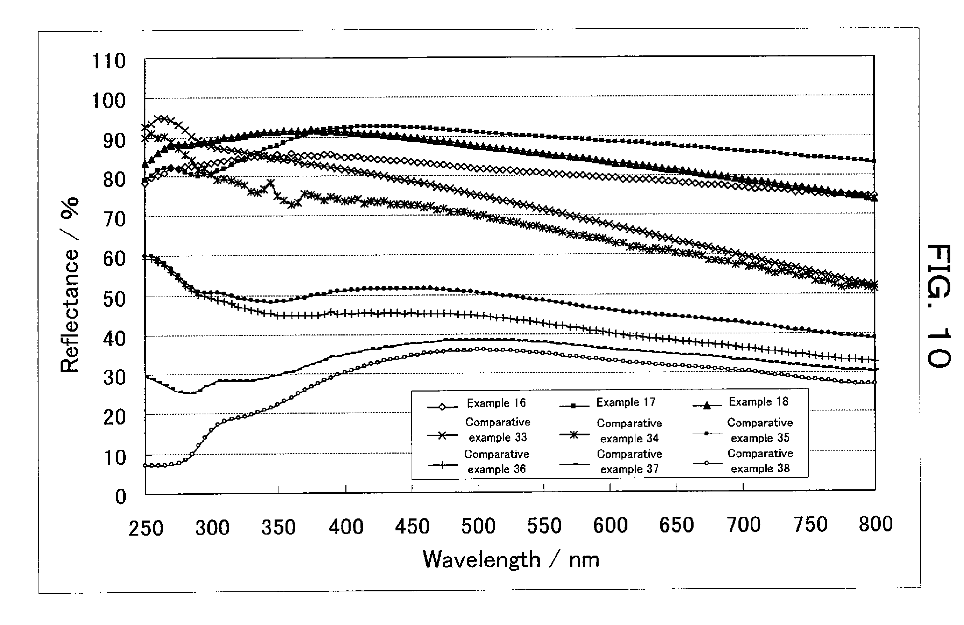

Except for using S-3, as an aluminum nitride board treated by mirror polishing to become 0.4mm in thickness, and for changing the oxidation temperature and oxidation time to same temperature and time shown in Table 8, Examples 16~18 and Comparative examples 33~38 were carried out in the same manner as Example 7.
The evaluation results of the various properties are shown in Table 8. Also, in FIG. 10, reflectance data in each wavelength of Examples 16~18 and Comparative examples 33~38 are shown.
(Table 8)

| | AlN thickness (mm) | Oxdation temperature (˚C) | Oxidation time (hr) | Atmosphere | | Oxidized film thickness ($\mu$m) | Reflectance (%) | | | Tape peeling test | Ratio of Number of voids | | Void content |
| | | | | Dew point | $O_2$ partial pressure (atm) | | 750nm | 300nm | 250nm | | <400nm | 400-800nm | |
|---|---|---|---|---|---|---|---|---|---|---|---|---|---|
| Example 16 | 0.4 | 1350 | 80 | 0-15˚C | 0.21 atm | Not measured | 75.8 | 83.1 | 78.3 | ◎ | - | - | - |
| Example 17 | 0.4 | 1350 | 15 | 0-15˚C | 0.21 atm | 63 | 84.5 | 80.6 | 79.2 | ◎ | - | - | - |
| Example 18 | 0.4 | 1300 | 5 | 0-15˚C | 0.21 atm | 32 | 76.4 | 89.0 | 83.3 | ◎ | - | - | - |
| Comparative example 33 | 0.4 | 1300 | 1 | 0-15˚C | 0.21 atm | 17 | 55.6 | 87.7 | 92.6 | ◎ | - | - | - |
| Comparative example 34 | 0.4 | 1200 | 5 | 0-15˚C | 0.21 atm | 11 | 54.7 | 80.5 | 89.9 | ◎ | - | - | - |
| Comparative example 35 | 0.4 | 1200 | 1 | 0-15˚C | 0.21atm | 3 | 40.5 | 50.7 | 60.2 | ◎ | - | - | - |
| Comparative example 36 | 0.4 | 1100 | 15 | 0-15˚C | 0.21 atm | 4 | 34.4 | 49.3 | 59.4 | ◎ | - | - | - |
| Comparative example 37 | 0.4 | 1100 | 5 | 0-15˚C | 0.21atm | 2 | 31.5 | 27.7 | 29.6 | ◎ | - | - | - |
| Comparative example 38 | 0.4 | 1100 | 1 | 0-15˚C | 0.21atm | 1 | 28.2 | 16.1 | 7.3 | ◎ | - | - | - |

If heating is done in an atmosphere of which dew point is adjusted in the range at least 0~15°C, and thickness of the oxidized layer is set to at least 30μm or more, and if S-3, which could not be able to show satisfactory reflectance by long-time oxidation under atmosphere of which dew point is -70°C, is used as an aluminum nitride board, it can be converted into a sintered body having preferable reflectance.

**Claims**

1. A sintered ceramics for mounting light-emitting element comprising a sintered ceramics,
   wherein said sintered ceramics has a light-reflective face of which reflectance to light in each wavelength in a range of 250nm~750nm is 70% or more;
   said light-reflective face satisfies following relation (1):

$$\left| R_A - R_B \right| \leq 20 \qquad (1)$$

   when reflectance to light of 750nm is defined as $R_A$%, and reflectance to light of 300nm is defined as $R_B$%; and said sintered ceramics has no layer to be peeled from said light-reflective face when Tape Peeling Test is carried out to said light-reflective face in accordance with the method described in JIS H8504 (1990).

2. The sintered ceramics for mounting light-emitting element according to claim 1,
   wherein a specific region from surface of at least one face to at least 15μm depth of said sintered ceramics has a plurality of voids of which diameter is 100nm~2000nm and said voids are mutually independent,
   ratio of number of the voids of less than 400nm in diameter to total number of the voids is 30~90%, and
   ratio of number of the voids of 400nm or more and less than 800nm in diameter to total number of the voids is 10~70%.

3. The sintered ceramics for mounting light-emitting element according to claim 2, wherein ratio of total volume of said voids to total volume of said specific region is 5~30%.

4. The sintered ceramics for mounting light-emitting element according to claim 2 or 3, wherein said specific region contains α-alumina as a main component.

5. The sintered ceramics for mounting light-emitting element according to claim 2 or 3, wherein said specific region contains α-alumina as a main component, and a portion other than said specific region contains aluminum nitride as a main component.

6. The sintered ceramics for mounting light-emitting element according to claim 2 or 3, wherein said specific region forms an entirety of said sintered ceramics, said specific region contains α-alumina as a main component.

7. A method for fabricating sintered ceramics for mounting light-emitting element described in any one of claims 1~3, said method comprising the steps of:

   preparing a raw sintered ceramics capable to react with reactive gas; and forming said specific region by reacting said raw sintered ceramics and said reactive gas,

   wherein a reaction of said raw sintered ceramics and said reactive gas is carried out under a condition such that a plurality of voids of which diameter is 100nm~2000nm are formed in said specific region and said voids are mutually independent.

8. A method for fabricating sintered ceramics for mounting light-emitting element described in claim 5 or 6, said method comprising the steps of:

   preparing a sintered aluminum nitride; and forming said specific region containing α-alumina as a main component by reacting said sintered aluminum nitride and oxygen,

   wherein a reaction of said sintered aluminum nitride and oxygen is carried out under a condition such that a plurality of voids of which diameter is 100nm~2000nm are formed in said specific region containing α-alumina as a main component and said voids are mutually independent.

9. The sintered ceramics for mounting light-emitting element according to any one of claims 1~6, wherein reflectance of the sintered ceramics to light in each wavelength in the range of 250nm~750nm is 75% or more.

10. A method for fabricating sintered ceramics for mounting light-emitting element described in claim 9, said method comprising the steps of:

preparing a sintered aluminum nitride; and heating said sintered aluminum nitride at a temperature of 1300˚C or more under atmosphere containing oxygen gas and of which dew point is set in a range of 0~15˚C, until a portion from a surface to at least 15$\mu$m depth or more of said sintered aluminum nitride is oxidized into alumina, and for a period of time or more which requires to oxidize the portion from surface to at least 30$\mu$m depth of said sintered aluminum nitride into alumina when partial pressure of the oxygen gas is 0.21 atm.

11. A method for fabricating sintered ceramics for mounting light-emitting element described in claim 9, said method comprising the steps of:

preparing a sintered aluminum nitride containing at least one of sintering aides component; and heating said sintered aluminum nitride at a temperature of 1300˚C or more under atmosphere containing oxygen gas and of which dew point is set in the range of -70˚C or less, until a portion from the surface to at least 20$\mu$m depth of said sintered aluminum nitride is oxidized into alumina.

12. A ceramics package for light-emitting element comprising said sintered ceramics for mounting light-emitting element described in any one of claims 1~6, and 9.

# FIG. 1

FIG. 2

# FIG. 3

# FIG. 4

# FIG. 5

## FIG. 6

Legend:
- Example 7
- Example 8
- Example 9
- Comparative example 20
- Comparative example 21

Y-axis: Reflectance / %

X-axis: Wavelength / nm

# FIG. 7

# FIG. 8

# FIG. 9

# FIG. 10

## FIG. 11(a)

Acc.V  Spot Magn  Det  WD
10.0 kV 3.0  5000x  TLD  5.0  TUSK-130  5 µm

## FIG. 11(b)

Acc.V  Spot Magn  Det  WD
10.0 kV 3.0  30000x  TLD  5.0  TUSK-130  1 µm

FIG. 12(a)

FIG. 12(b)

<table>
<tr><td colspan="2" align="center">**INTERNATIONAL SEARCH REPORT**</td><td>International application No.<br>PCT/JP2006/319011</td></tr>
</table>

| A. CLASSIFICATION OF SUBJECT MATTER |
|---|
| *C04B35/111*(2006.01)i, *C04B35/581*(2006.01)i, *H01L33/00*(2006.01)i |

According to International Patent Classification (IPC) or to both national classification and IPC

| B. FIELDS SEARCHED |
|---|

Minimum documentation searched (classification system followed by classification symbols)
C04B35/00-35/84, H01L33/00, H01S5/00-5/50

Documentation searched other than minimum documentation to the extent that such documents are included in the fields searched

| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)
JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| Y<br>A | JP 62-123071 A (Kyocera Corp.),<br>04 June, 1987 (04.06.87),<br>Page 2, upper left column, line 11 to<br>page 3, lower left column, line 11;<br>table 1; Fig. 1<br>(Family: none) | 1-5,7-12<br>6 |
| Y<br>A | JP 2004-207678 A (Kyocera Corp.),<br>22 July, 2004 (22.07.04),<br>Par. Nos. [0015], [0031] to [0040]; Fig. 1<br>(Family: none) | 1-5,7-12<br>6 |
| P,X | JP 2006-108180 A (Kyoritsu Elex Co., Ltd.),<br>20 April, 2006 (20.04.06),<br>Par. Nos. [0016] to [0042]; table 1; Fig. 14<br>(Family: none) | 1-4,6,7,9,12 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>12 October, 2006 (12.10.06) | Date of mailing of the international search report<br>24 October, 2006 (24.10.06) |
|---|---|
| Name and mailing address of the ISA/<br>Japanese Patent Office | Authorized officer |
| Facsimile No. | Telephone No. |

Form PCT/ISA/210 (second sheet) (April 2005)

| **INTERNATIONAL SEARCH REPORT** | International application No. |
|---|---|
| | PCT/JP2006/319011 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 02-044084 A  (Asahi Glass Co., Ltd.),<br>14 February, 1990 (14.02.90),<br>Page 2, upper left column, line 15 to<br>page 4, upper left column, line 13<br>(Family: none) | 1-12 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003060243 A

- JP 2005277048 A